(19) Europäisches Patentamt
European Patent Office
Office européen des brevets

(11) **EP 3 764 392 B1**

(12) **EUROPEAN PATENT SPECIFICATION**

(45) Date of publication and mention
of the grant of the patent:
**09.08.2023 Bulletin 2023/32**

(21) Application number: **19764636.7**

(22) Date of filing: **08.02.2019**

(51) International Patent Classification (IPC):
**H01L 21/66** *(2006.01)*  **C30B 29/06** *(2006.01)*
**G01N 21/62** *(2006.01)*  **C30B 33/04** *(2006.01)*
**G01N 23/2254** *(2018.01)*

(52) Cooperative Patent Classification (CPC):
**C30B 33/04; C30B 29/06; G01N 23/2254;**
G01N 2223/604; G01N 2223/6116; G01N 2223/652

(86) International application number:
**PCT/JP2019/004687**

(87) International publication number:
**WO 2019/171880 (12.09.2019 Gazette 2019/37)**

(54) **OXYGEN CONCENTRATION EVALUATION METHOD**

**VERFAHREN ZUR BESTIMMUNG DER SAUERSTOFFKONZENTRATION**

**PROCÉDÉ D'ÉVALUATION DE CONCENTRATION D'OXYGÈNE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.03.2018 JP 2018042902**

(43) Date of publication of application:
**13.01.2021 Bulletin 2021/02**

(73) Proprietor: **Shin-Etsu Handotai Co., Ltd.**
**Tokyo 100-0004 (JP)**

(72) Inventors:
• **KUBONO, Ippei**
**Nishishirakawa-gun, Fukushima 961-8061 (JP)**

• **KIMURA, Akihiro**
**Nishishirakawa-gun, Fukushima 961-8061 (JP)**

(74) Representative: **Wibbelmann, Jobst**
**Wuesthoff & Wuesthoff**
**Patentanwälte PartG mbB**
**Schweigerstrasse 2**
**81541 München (DE)**

(56) References cited:
**JP-A- 2014 199 253    JP-A- 2015 101 529**
**JP-A- 2015 101 529    US-B2- 9 773 710**

**Description**

TECHNICAL FIELD

The present invention relates to a method for evaluating an oxygen concentration in a silicon single crystal.

BACKGROUND ART

Methods for measuring an impurity concentration in a silicon single crystal with high sensitivity include low-temperature photoluminescence (PL) methods.

Two kinds of method for quantifying an oxygen concentration by a low-temperature PL method are disclosed in Patent Document 1. The first method is a method of irradiating a sample with an electron beam, and a carbon ion or an oxygen ion to form composite defects and measuring a luminescence intensity attributable to the composite defects to quantify the oxygen concentration from the intensity. The second method is a method of irradiating a sample with a large quantity of carbon ion beam to form composite defects and measuring a luminescence intensity attributable to the composite defects to quantify the oxygen concentration from the intensity.

In addition, as a method for quantifying a carbon concentration by a low-temperature PL method, for example, Non Patent Document 1 and Patent Document 1 disclose a method of irradiating a sample with an electron beam, or an ion beam of a carbon ion or an oxygen ion to form composite defects and measuring a luminescence intensity attributable to the composite defects to quantify the carbon concentration from the intensity.

Patent Document 2 discloses a method of preparing a calibration curve from a value obtained by standardizing, with the use of an emission line (TO line) derived from silicon, a luminescence spectrum (W line) derived from interstitial silicon (I) introduced by irradiating the silicon single crystal with an electron beam, and a carbon concentration in the silicon single crystal, and quantifying the carbon concentration from the W line/TO line obtained by a luminescence method.

Patent Document 3 discloses a method of injecting ions other than carbon or oxygen into a silicon single crystal, preparing a calibration curve from a luminescence spectrum intensity of interstitial carbon, Ci-Cs, or Ci-Oi formed in this manner, and a carbon concentration, and quantifying the carbon concentration from a spectrum intensity of carbon-related composite defects.

An FT-IR method or a SIMS method is generally used as a method for measuring an oxygen concentration in a silicon single crystal. Lower detection limits thereof are 0.07 (ppma-JEITA) in the FT-IR method, and 0.02 (ppma) in the SIMS method. Patent Document 4 discloses a method of measuring carbon concentration of a silicon single crystal in which unknown carbon concentration is measured from correlation set by acquiring an intensity division value obtained by dividing intensity of a spectrum of 1,280 nm in wavelength by intensity of a spectrum of 1,570 nm in wavelength and a concentration division value obtained by dividing carbon concentration measured from each silicon single crystal by oxygen concentration with respect to photoluminescence or cathode luminescence due to a composite defect of a silicon single crystal generated by irradiating the silicon single crystal with an electron beam, and oxygen concentration measured from a silicon single crystal for measurement whose carbon concentration is unknown and an intensity division value acquired by irradiating the silicon single crystal for measurement with an electron beam.

CITATION LIST

PATENT LITERATURE

Patent Document 1: JP H04-344443 A
Patent Document 2: JP 2015-111615 A
Patent Document 3: JP 2015-156420 A
Patent Document 4: JP 2015-101529 A

NON PATENT LITERATURE

Non Patent Document 1: M. Nakamura et al.,J.Electochem.Soc.141,3576(1994)

## SUMMARY OF INVENTION

### TECHNICAL PROBLEM

Methods for measuring an impurity concentration with high sensitivity by measuring an intensity of composite defects formed in a silicon single crystal include low-temperature PL methods, but as described above, many of the methods are methods for measuring a carbon concentration.

Patent Document 1 discloses a method for measuring an oxygen concentration by a low-temperature PL method, which is a method of determining the oxygen concentration by irradiating with a large quantity of carbon ion beam or both an electron beam and an ion beam. However, when irradiation is performed with an ion beam of oxygen or carbon, the ions for irradiation affect the formation of Ci-Cs and Ci-Oi, and therefore, the oxygen concentration determined using this photoluminescence intensity is inaccurate.

In addition, as described above, an FT-IR method and a SIMS method are common as methods for measuring an oxygen concentration in a silicon single crystal, but sensitivity is poor with these methods, and lower detection limits thereof are 0.07 (ppma-JEITA) in the FT-IR method, and 0.02 (ppma) in the SIMS method.

When oxygen is present in a silicon single crystal, Ci-Oi is apt to be formed. Since these composite defects become lifetime killers, which shorten lifetime, low oxygen is desired particularly in power devices. Accordingly, it is important to measure oxygen with high sensitivity.

The present invention has been made in view of the problems in the above-described conventional technology, and an object thereof is to provide a method for evaluating an oxygen concentration in a silicon single crystal with high sensitivity.

### SOLUTION TO PROBLEM

To achieve the object, the present invention provides a method for evaluating an oxygen concentration of evaluating an oxygen concentration in a silicon single crystal by a photoluminescence method or a cathode luminescence method, wherein

the silicon single crystal is irradiated with an electron beam at a predetermined dose or an ion beam other than carbon or oxygen at a predetermined dose, intensity of an emission line (C line) derived from composite defects Ci-Oi of interstitial carbon Ci and interstitial oxygen Oi formed in the silicon single crystal and intensity of an emission line (G line) derived from composite defects Ci-Cs of interstitial carbon Ci and substitutional carbon Cs formed in the silicon single crystal are measured at a predetermined temperature, an intensity ratio of the C line and the G line (Ci-Oi intensity/Ci-Cs intensity) is determined,
a carbon concentration [Cs] in the silicon single crystal is measured and
the oxygen concentration [Oi] is evaluated by
substituting the intensity ratio (Ci-Oi intensity/Ci-Cs intensity) and the carbon concentration [Cs] in the silicon single crystal into the following equation:

$$[Oi]=\alpha \cdot (Ci\text{-}Oi\ intensity/Ci\text{-}Cs\ intensity) \cdot [Cs]$$

(where $\alpha$ is a proportionality constant), wherein
when evaluating the oxygen concentration, the following is performed in advance:

a test crystal which is a silicon single crystal with a known oxygen concentration and a known carbon concentration is prepared,
the test crystal is irradiated with the electron beam at the predetermined dose or the ion beam other than carbon or oxygen at the predetermined dose, intensity of a C line and intensity of a G line formed in the test crystal are measured at a predetermined temperature, an intensity ratio of the C line and the G line (Ci-Oi intensity/Ci-Cs intensity) in the test crystal is determined, and
a value of the proportionality constant $\alpha$ is determined from the oxygen concentration and the carbon concentration in the test crystal, the intensity ratio of the C line and the G line in the test crystal (Ci-Oi intensity/Ci-Cs intensity), and the equation.

The method for evaluating an oxygen concentration of the present invention by a photoluminescence method or a cathode luminescence (CL) method as described makes it possible to quantify oxygen concentration with high sensitivity from the ratio of the luminescence intensities of the carbon-related composite defects (the composite defects Ci-Oi and the composite defects Ci-Cs described above) in the silicon single crystal and the carbon concentration in the silicon single crystal.

When evaluating the oxygen concentration, the following is performed in advance:

a test crystal which is a silicon single crystal with a known oxygen concentration and a known carbon concentration is prepared,

the test crystal is irradiated with the electron beam at the predetermined dose or the ion beam other than carbon or oxygen at the predetermined dose, intensity of a C line and intensity of a G line formed in the test crystal are measured at a predetermined temperature, an intensity ratio of the C line and the G line (Ci-Oi intensity/Ci-Cs intensity) in the test crystal is determined, and

a value of the proportionality constant $\alpha$ is determined from the oxygen concentration and the carbon concentration in the test crystal, the intensity ratio of the C line and the G line in the test crystal (Ci-Oi intensity/Ci-Cs intensity), and the equation.

The proportionality constant $\alpha$ varies depending on the temperature (sample temperature) when measuring the luminescence intensity and the conditions (dose) of the electron-beam irradiation and the ion-beam irradiation, and therefore, when an oxygen concentration of a silicon single crystal substrate is measured at a different sample temperature, electron-beam irradiation conditions or ion-beam irradiation conditions, the proportionality constant $\alpha$ is more preferably determined for each case. Accordingly, as described above, the preliminary test described above can be performed using a test crystal to determine in advance the proportionality constant $\alpha$ under the same conditions as when the oxygen concentration in the silicon single crystal to be evaluated is evaluated. In this manner, various conditions can be addressed more appropriately, and the oxygen concentration can be evaluated with higher precision.

Or else when the predetermined dose of the electron beam when irradiating the silicon single crystal is set to $1.0 \times 10^{15}$ (electrons/cm²), the predetermined temperature when measuring the intensity of the C line and the intensity of the G line is set to liquid helium temperature, a unit of the carbon concentration is (atoms/cm³), a unit of the oxygen concentration is (ppma-JEITA), and the C line intensity and the G line intensity are relative values,

a value of the proportionality constant $\alpha$ can be set to $2.25 \times 10^{-15}$.

Or, when the predetermined dose of the electron beam when irradiating the silicon single crystal is set to $1.0 \times 10^{15}$ (electrons/cm²), the predetermined temperature when measuring the intensity of the C line and the intensity of the G line is set to liquid nitrogen temperature, a unit of the carbon concentration is (atoms/cm³), a unit of the oxygen concentration is (ppma-JEITA), and the C line intensity and the G line intensity are relative values,

a value of the proportionality constant $\alpha$ can be set to $3.55 \times 10^{-15}$.

When a silicon single crystal substrate is evaluated in accordance with the above sample temperature and dose of the electron beam or the like, the oxygen concentration can be quantified immediately just by measuring the luminescence intensity of the carbon-related composite defects and the carbon concentration. By thus fixing the conditions of the sample temperature and the dose of the electron beam or the like, the oxygen concentration can be evaluated more simply without preparing a calibration curve, etc.

Furthermore, the ion beam for irradiating the silicon single crystal other than carbon or oxygen can be an ion beam of one or more of boron, phosphorus, arsenic, antimony, hydrogen, helium, argon, germanium, fluorine, nitrogen, silicon, aluminum, indium, and xenon.

In conventional methods that use an ion beam of oxygen or carbon, the ions for irradiation affect the formation of carbon-related composite defects, and this has an effect on the oxygen concentration to be evaluated. However, by using an ion beam of one or more of the above as in the present invention, such effects can be prevented more certainly from occurring.

Furthermore, the carbon concentration in the silicon single crystal can be $1.0 \times 10^{14}$ (atoms/cm³) or more.

On substituting the carbon concentration into the equation, the carbon concentration in the silicon single crystal to be evaluated can be set within the above range so that the carbon concentration can be measured with more certainty by an FT-IR method or a SIMS method, for example, when determining the carbon concentration.

ADVANTAGEOUS EFFECTS OF INVENTION

As described above, an oxygen concentration can be evaluated by the inventive method for evaluating an oxygen concentration with higher sensitivity than by conventional methods.

BRIEF DESCRIPTION OF DRAWINGS

FIG. 1 is a flow diagram showing an example of the steps of the inventive method for evaluating an oxygen concentration.

FIG. 2 is a graph showing the relation of the proportionality constant $\alpha$ when the sample temperature is liquid helium temperature to the oxygen concentration in a silicon single crystal.

FIG. 3 is a graph showing the relation between the oxygen concentrations evaluated in the Example and the Comparative Example (FT-IR method).

FIG. 4 is a graph showing the evaluation data of the samples having oxygen concentrations of less than 0.07 (ppma-JEITA) in the Example.

## DESCRIPTION OF EMBODIMENTS

Hereinafter, embodiments of the present invention will be described with reference to the figures, but the present invention is not limited thereto.

Firstly, the process by which the present inventors have derived an equation (oxygen concentration relational equation) by which the oxygen concentration in the silicon single crystal can be evaluated from the carbon concentration in the silicon single crystal, and the intensity ratio (Ci-Oi intensity/Ci-Cs intensity) of the Ci-Oi (C line) and the Ci-Cs (G line), which are carbon-related composite defects, will be described.

According to Non Patent Document 1, when a silicon single crystal substrate is irradiated with an electron beam having high energy, a silicon atom at a lattice position is flicked out, and pairs of an interstitial silicon (hereinafter, referred to as I) and a vacancy (hereinafter, referred to as V) which is an empty shell thereof are produced. Since the excessively produced I or V is unstable when alone, they recombine ($V+I\rightarrow0$), clustering of Is or clustering of Vs occurs, or they react with an impurity contained in the silicon substrate to form a composite.

When substitutional carbon Cs is present in the silicon single crystal substrate, interstitial carbon Ci is produced by I, which is produced by electron-beam irradiation, flicking out Cs. Furthermore, Ci forms Ci-Cs (G line) by reacting with other Cs, or forms Ci-Oi (C line) by reacting with interstitial oxygen Oi, which is another impurity contained in the silicon substrate.

When the equilibrium constants in the formation of this Ci-Cs and Ci-Oi are defined as $K_1$ and $K_2$ (the following expressions (1) and (2), and equation [4] and equation [5] in Non Patent Document 1), the following equations (3) and (4) are obtained since the formation of Ci-Cs and the formation of Ci-Oi are competing reactions.

Note that [Oi] indicates interstitial oxygen concentration (also referred to simply as oxygen concentration), [Cs] indicates substitutional carbon concentration (also referred to simply as carbon concentration), [Ci] indicates interstitial carbon concentration, [CiCs] indicates G line intensity (Ci-Cs intensity), and [CiOi] indicates C line intensity (Ci-Oi intensity).

$$\mathbf{Ci + Cs \overset{K_1}{\Leftrightarrow} Ci\text{-}Cs} \quad - (1)$$

$$\text{From (1), } K_1\,[Ci]\,[Cs] = \frac{[CiCs]}{K_1\,[Cs] + K_2\,[Oi]} \quad - (3)$$

$$\mathbf{Ci + Oi \overset{K_2}{\Leftrightarrow} Ci\text{-}Oi} \quad - (2)$$

$$\text{From (2), } K_2\,[Ci]\,[Oi] = \frac{[CiOi]}{K_1\,[Cs] + K_2\,[Oi]} \quad - (4)$$

Here, the following oxygen concentration relational equation (5) (hereinafter, also referred to simply as equation (5) or relational equation (5)) can be obtained by combining the like terms in the equations (3) and (4) and solving for [Oi].

$$[Oi] = \alpha \cdot \frac{[CiOi]}{[CiCs]} \cdot [Cs] \quad - (5) \qquad \alpha = \frac{K_1}{K_2}$$

Here, the proportionality constant $\alpha$ is a constant that varies depending on sample temperature, electron-beam irradiation conditions, and ion-beam irradiation conditions. This is because luminous efficiency of the G line and the C line change when the sample temperature is different, and the obtained G line intensity and C line intensity change. In addition, when the electron-beam irradiation conditions and the ion-beam irradiation conditions are different, the formation ratio of Ci-Cs and Ci-Oi becomes different, and therefore, the proportionality constant $\alpha$ changes.

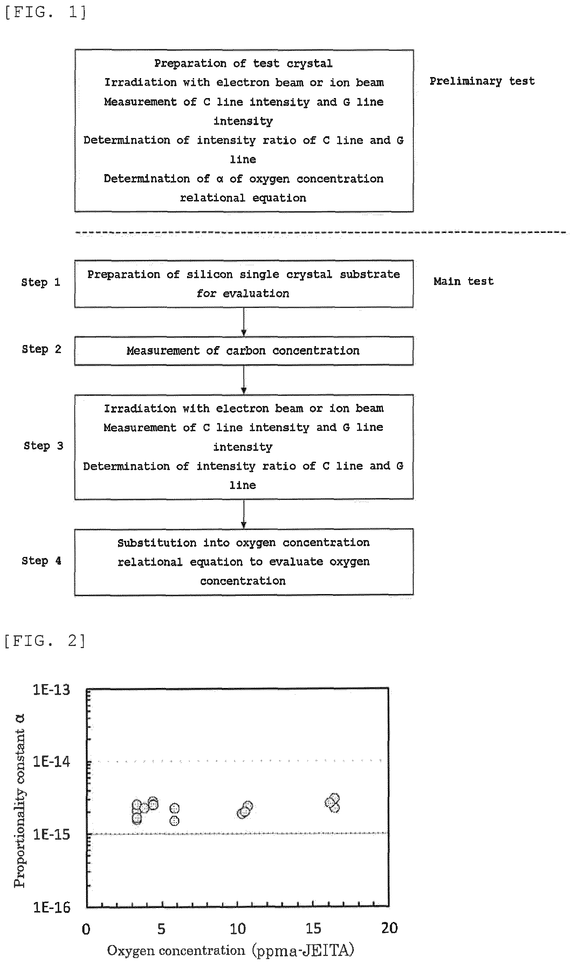

Hereinafter, the inventive method for evaluating an oxygen concentration using the oxygen concentration relational equation (5) will be described. FIG. 1 is a flow diagram showing the steps of the inventive method for evaluation. The example in FIG. 1 consists of a main test for evaluating a sample for evaluation and a preliminary test for determining the value of $\alpha$ in the equation (5) in advance. The preliminary test may be performed at any time as long as it is before the step 4 of the main test when carbon concentration, etc. are actually substituted into the equation (5).

(Preliminary Test)

The preliminary test will be described.

As stated above, the value of the proportionality constant $\alpha$ in the equation (5) varies depending on sample temperature, electron-beam irradiation conditions, and ion-beam irradiation conditions. Therefore, firstly, a test crystal which is a silicon single crystal with a known oxygen concentration and a known carbon concentration is prepared, and irradiation and measurement are performed under the same conditions as the main test (a sample temperature at a predetermined temperature, and an electron beam or an ion beam (other than carbon or oxygen) at a predetermined dose) to determine the intensity ratio (Ci-Oi intensity/Ci-Cs intensity) of the C line and the G line. Next, the value of the proportionality constant $\alpha$ is determined from the oxygen concentration and the carbon concentration in the test crystal, the intensity ratio (Ci-Oi intensity/Ci-Cs intensity) of the C line and the G line in the test crystal, and the equation (5).

In accordance with various conditions of the main test, a proportionality constant $\alpha$ can be obtained in advance in the preliminary test under the same conditions as the conditions of the main test, and in this manner, the oxygen concentration can be evaluated with higher precision in the main test.

Here, a more specific example will be given for explanation.

15 levels of silicon single crystal substrates (test crystal samples) with different carbon concentrations and oxygen concentrations were prepared by a CZ method.

A reason for preparing silicon single crystal substrates with different carbon concentrations is to verify that the oxygen concentration can be quantified from one relational equation even when the carbon concentration is different. Note that in order to make it possible to detect the oxygen concentration with more certainty by FT-IR, and in order to prevent with more certainty the S/N ratio of the G line from being degraded due to increase of spending the Ci for the formation of a C line, the oxygen concentration range of the silicon single crystal substrates prepared here was 3 to 17 (ppma-JEITA).

Furthermore, samples of 15 levels were prepared here, where at least 5 levels are desired, to improve the precision of the proportionality constant $\alpha$ to be obtained.

Next, the carbon concentration of these samples was measured by a SIMS method and the oxygen concentration of these samples was measured by an FT-IR method.

Subsequently, each silicon single crystal substrate was irradiated with an electron beam of $1.0 \times 10^{15}$ (electrons/cm$^2$) at an acceleration voltage of 2 (MV) by an electron beam irradiation apparatus to form Ci-Cs and Ci-Oi in the silicon single crystal substrate, and the peak intensities thereof were measured by a photoluminescence method. The sample temperature at the time of this measurement was set to liquid helium temperature.

In these silicon single crystal substrates, the obtained oxygen concentration, carbon concentration, G line intensity, and C line intensity were substituted into the above equation (5), and the obtained proportionality constant $\alpha$ was plotted on the graph in relation to the oxygen concentration. The results are shown in FIG. 2.

Since the proportionality constant $\alpha$ showed an almost constant value, the average of the 15 levels of sample was taken as the $\alpha$, and $2.25 \times 10^{-15}$ was obtained. Here the units are each (atoms/cm$^3$) for the carbon concentration, (ppma-JEITA) for the oxygen concentration, and relative value (a.u.) for the G line intensity and the C line intensity.

The oxygen concentration relational equation (6) under these conditions was determined from the above.

$$[\text{Oi}] \ (\text{ppma-JEITA}) \ = \ (2.25 \times 10^{-15}) \ \cdot \ \frac{[\text{CiOi}] \ (\text{a.u.})}{[\text{CiCs}](\text{a.u.})} \ \cdot \ [\text{Cs}] \ (\text{atoms/cm}^3) \qquad - (6)$$

In addition, when the proportionality constant $\alpha$ with the sample temperature as liquid nitrogen was determined by the same method, $3.55 \times 10^{-15}$ was obtained.

(Main Test)

Next, the main test will be described.

Firstly, in the present invention, a silicon single crystal substrate, which is a sample for evaluation is prepared (step 1). This silicon single crystal substrate is not particularly limited, and may be made by a Czochralski method (CZ method) or a floating zone method (FZ method), for example.

Note that on evaluating the oxygen concentration, the carbon concentration will be measured and substituted into the relational equation described above in subsequent steps, and the carbon concentration is preferably $1.0 \times 10^{14}$ (atoms/cm$^3$) or more, for example, so that it can be detected and measured more certainly in the measurement by FT-IR or SIMS, for example. That is, when the carbon concentration is $1.0 \times 10^{14}$ (atoms/cm$^3$) or more, the carbon concentration can be determined with higher precision, and therefore, precision of the oxygen concentration determined in the present invention can also be raised. The upper limit of the carbon concentration is not limited, and can be any value as long as it can be measured.

In addition, the oxygen concentration itself is not particularly limited.

Next, the carbon concentration (substitutional carbon concentration) of the sample for evaluation is measured (step 2). The measurement can be by the FT-IR method or the SIMS method, for example. The method for measuring the carbon concentration can be any method as long as the carbon concentration in the sample for evaluation can be determined, and is not particularly limited.

Next, by the PL method or the CL method, the sample for evaluation is irradiated with an electron beam or an ion beam other than carbon or oxygen, intensity of an emission line (C line) derived from formed composite defects Ci-Oi and emission intensity of an emission line (G line) derived from formed composite defects Ci-Cs are measured, and the intensity ratio of the C line and the G line is determined (step 3). The peak intensity of each is measured, and the ratio thereof is determined.

In this event, the temperature of the sample for evaluation can be, for example, liquid helium temperature or liquid nitrogen temperature. The temperature is not particularly limited, but at such temperatures, the G line and the C line have broad peaks, and the correct intensity can be prevented more effectively from becoming impossible to measure.

In addition, the electron beam dose can be set within the range of $2.5 \times 10^{14}$ to $2.5 \times 10^{16}$ (electrons/cm$^2$), for example. When the dose is within this range, problems such as Ci-Cs or Ci-Oi not being formed due to the electron beam dose being too little can be prevented from occurring with more certainty. Furthermore, it is possible to prevent more certainly, the silicon lattice from becoming disarranged due to the electron beam dose being too large and the S/N ratio of the G line or the C line from being degraded.

In addition, the measurement depth can be changed in the CL method by changing the acceleration voltage of electrons, and in the PL method by changing the wavelength of the laser light, and therefore, it is possible to evaluate up to a desired depth from the sample surface by adjusting these conditions.

Next, the carbon concentration and the intensity ratio of the C line and the G line are substituted into the above oxygen concentration relational equation (5) to evaluate the oxygen concentration (step 4).

As the value of the proportionality constant $\alpha$ in the equation (5), the value of the proportionality constant $\alpha$ determined in the preliminary test under the same conditions as the main test (the sample temperature at the predetermined temperature, the electron beam at the predetermined dose, or the ion beam other than carbon or oxygen at the predetermined dose) can be used.

Other than that, as already clarified in the above-described example, when the predetermined dose of the electron beam when irradiating the silicon single crystal is set to $1.0 \times 10^{15}$ (electrons/cm$^2$), the predetermined temperature when measuring the intensity of the C line and the intensity of the G line is set to liquid helium temperature, the unit of the carbon concentration is (atoms/cm$^3$), the unit of the oxygen concentration is (ppma-JEITA), and the C line intensity and the G line intensity are relative values, the value of the proportionality constant $\alpha$ can be set to $2.25 \times 10^{-15}$ without performing the preliminary test (that is, the equation (6)).

On the other hand, when the predetermined dose of the electron beam when irradiating the silicon single crystal is set to $1.0 \times 10^{15}$ (electrons/cm$^2$), the predetermined temperature when measuring the intensity of the C line and the intensity of the G line is set to liquid nitrogen temperature, the value of the proportionality constant $\alpha$ can be set to $3.55 \times 10^{-15}$ without performing the preliminary test.

Under the above conditions, the proportionality constant $\alpha$ can be determined without the need for a preliminary test or preparation of a calibration curve, and the oxygen concentration can be evaluated more simply. Note that, as a matter of course, the proportionality constant $\alpha$ is not limited thereto.

Furthermore, the proportionality constant $\alpha$ is different when the electron beam dose is not $1.0 \times 10^{15}$ (electrons/cm$^2$), or when ion beam irradiation is performed instead of the electron beam irradiation. In that case, it is possible to determine the proportionality constant $\alpha$ by substituting the oxygen concentration, the carbon concentration, the G line intensity, and the C line intensity obtained by a sample measurement into the relational equation (5) in the same manner, calculating the proportionality constant $\alpha$ for each sample, and determining the average thereof as the preliminary test.

In addition, as the ion-beam irradiation conditions, the dose can be within the range of $1 \times 10^{12}$ to $1 \times 10^{14}$ (atoms/cm$^3$), for example. In this range, sufficient carbon-related composite defects for measuring can be formed, and the time required for the ion-beam irradiation does not become too long.

In addition, if an ion beam of oxygen or carbon is used for irradiation, the oxygen concentration to be measured is affected, and therefore, the ion beam is preferably of an ion of one or more selected from boron, phosphorus, arsenic, antimony, hydrogen, helium, argon, germanium, fluorine, nitrogen, silicon, aluminum, indium, and xenon.

By such an inventive method for evaluation, the oxygen concentration can be quantified from the carbon concentration, the G line intensity, and the C line intensity in a silicon single crystal substrate with an unknown oxygen concentration.

Furthermore, there are no limits to the oxygen concentration that can be quantified by this method, and oxygen concentrations of various ranges can be quantified. For example, the lower detection limit of the oxygen concentration is 0.07 (ppma-JEITA) in the FT-IR method and 0.02 (ppma) in the SIMS method, but oxygen concentrations at or less than these lower detection limits can be quantified by the inventive method for evaluating an oxygen concentration.

EXAMPLE

Hereinafter, the present invention will be described more specifically with reference to Examples of the present invention and Comparative Examples, but the present invention is not limited thereto.

(Example)

The inventive method for evaluating an oxygen concentration was performed to evaluate the oxygen concentration of the silicon single crystals for evaluation.

The temperature of every sample handled here was liquid helium temperature, and electron-beam irradiation conditions were: an acceleration voltage of 2 (MV); and a dose of $1.0 \times 10^{15}$ (electrons/cm$^2$).

The value of the $\alpha$ in the equation (5) can be determined by performing a preliminary test, but under the above conditions, the value of the proportionality constant $\alpha$ was set to $2.25 \times 10^{-15}$ as already made clear in the above specific example. That is, the equation (6) was used here.

Subsequently, silicon single crystal wafers were cut out from silicon single crystal ingots with different carbon concentrations and oxygen concentrations pulled by a CZ method or an FZ method to fabricate 105 samples (hereinafter, referred to as samples for oxygen concentration measurement).

Next, the carbon concentrations of the samples for oxygen concentration measurement were measured by a SIMS method. As a result, the carbon concentrations of the 105 samples were within the range of $1.0 \times 10^{14}$ to $7.3 \times 10^{15}$ (atoms/cm$^3$) .

Subsequently, the samples for oxygen concentration measurement were irradiated with an electron beam using an electron beam irradiation apparatus (an acceleration voltage of 2 (MV) and a dose of $1.0 \times 10^{15}$ (electrons/cm$^2$)). Emission spectra of the samples for oxygen concentration measurement irradiated with the electron beam were measured using a photoluminescence measurement apparatus with the sample temperature as liquid helium temperature, and a G line intensity and a C line intensity were obtained.

These values were substituted into the relational equation (6), and the oxygen concentration of each sample for oxygen concentration measurement was calculated.

Note that the oxygen concentrations determined here were compared with values determined by an FT-IR method, which is a conventional method, to confirm the adequacy of the inventive evaluation method. Accordingly, the Comparative Examples performed by a conventional method will be described next.

(Comparative Example)

Samples for oxygen concentration measurement similar to those in the Example were prepared, and the oxygen concentrations thereof were evaluated by the FT-IR method and the SIMS method.

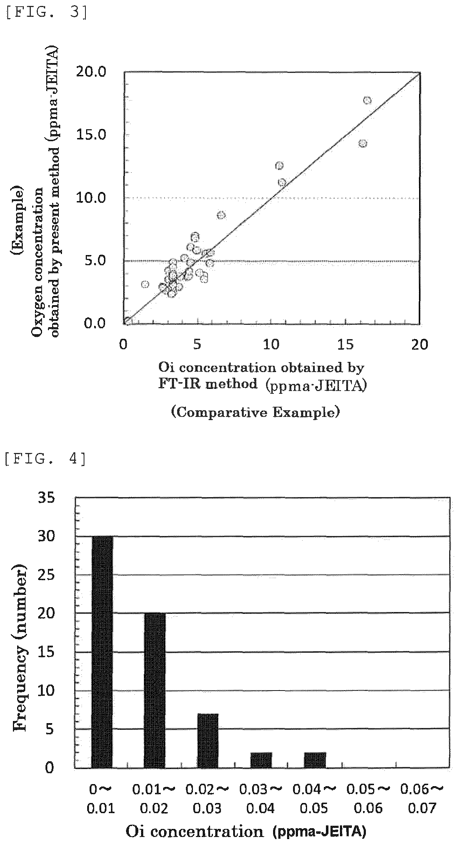

Regarding the samples for oxygen concentration measurement, the relation between the oxygen concentrations (the oxygen concentrations in the Comparative Example) quantified by the FT-IR method, which is a conventional method, and the oxygen concentrations (the oxygen concentrations in the Example) quantified by the inventive method were plotted in FIG. 3.

Here, since oxygen concentrations of less than 0.07 (ppma-JEITA) cannot be quantified by the FT-IR method, the evaluation data of the samples in the Example with oxygen concentrations of less than 0.07 (ppma-JEITA) are shown separately in FIG. 4.

Since the oxygen concentrations evaluated by the inventive method (Example) were well consistent with the oxygen concentrations evaluated by the conventional method (Comparative Example) in FIG. 3, it was confirmed that the present invention was valid.

Furthermore, when the oxygen concentrations of 2 samples out of the samples shown in FIG. 4 were evaluated by the SIMS method (Comparative Example), the oxygen concentrations (0.022 ppma) of the samples that were detected by the SIMS method were extremely consistent with the oxygen concentrations (Example: 0.023 ppma) detected by the present invention, and the adequacy of the present invention was confirmed. In addition, the oxygen concentrations of the samples that were the lower detection limit (0.02 ppma) or less in the SIMS method (Comparative Example) were 0.013 ppma when detected by the present invention (Example), and there were no inconsistencies in the result.

From the above results, it was confirmed that even oxygen concentrations in a range that cannot be quantified by the FT-IR method, whose lower detection limit is 0.07 (ppma-JEITA) or the SIMS method, whose lower detection limit is 0.02 (ppma) can be quantified by the inventive evaluation method, since the luminescence intensities of the C line and the G line can be obtained.

In this manner, the inventive evaluation method makes it possible to quantify an oxygen concentration from the ratio of the luminescence intensities of a C line and a G line and from the carbon concentration in the silicon single crystal. Moreover, the evaluation can be performed with high sensitivity.

In addition, when an oxygen concentration was determined in the same manner as in the Example except that the sample temperature at the time of the measurement by the PL method was set to liquid nitrogen temperature and that the value of the proportionality constant $\alpha$ in the equation for calculating the oxygen concentration was changed to $3.55 \times 10^{-15}$, similar results to those in FIGs. 3 and 4 were obtained.

Furthermore, when a preliminary test was performed under different electron-beam irradiation conditions and sample temperature to determine the proportionality constant $\alpha$ and a main test was performed to determine an oxygen concentration, again, similar results were obtained.

## Claims

1. A method for evaluating an oxygen concentration in a silicon single crystal by a photoluminescence method or a cathode luminescence method, wherein

   the silicon single crystal is irradiated with an electron beam at a predetermined dose or an ion beam other than carbon or oxygen at a predetermined dose, intensity of an emission line (C line) derived from composite defects Ci-Oi of interstitial carbon Ci and interstitial oxygen Oi formed in the silicon single crystal and intensity of an emission line (G line) derived from composite defects Ci-Cs of interstitial carbon Ci and substitutional carbon Cs formed in the silicon single crystal are measured at a predetermined temperature, an intensity ratio of the C line and the G line (Ci-Oi intensity/Ci-Cs intensity) is determined,
   a carbon concentration [Cs] in the silicon single crystal is measured and
   the oxygen concentration [Oi] is evaluated by
   substituting the intensity ratio (Ci-Oi intensity/Ci-Cs intensity) and the carbon concentration [Cs] in the silicon single crystal into the following equation:

   [Oi]=$\alpha$·(Ci-Oi intensity/Ci-Cs intensity)·[Cs] (where $\alpha$ is a proportionality constant), wherein
   when evaluating the oxygen concentration, the following is performed in advance:

   a test crystal which is a silicon single crystal with a known oxygen concentration and a known carbon concentration is prepared,
   the test crystal is irradiated with the electron beam at the predetermined dose or the ion beam other than carbon or oxygen at the predetermined dose, intensity of a C line and intensity of a G line formed in the test crystal are measured at a predetermined temperature, an intensity ratio of the C line and the G line (Ci-Oi intensity/Ci-Cs intensity) in the test crystal is determined, **characterized in that** a value of the proportionality constant $\alpha$ is determined from the oxygen concentration and the carbon concentration in the test crystal, the intensity ratio of the C line and the G line in the test crystal (Ci-Oi intensity/Ci-Cs intensity), and the equation.

2. The method for evaluating an oxygen concentration according to claim 1, wherein
   the ion beam for irradiating the silicon single crystal other than carbon or oxygen is an ion beam of one or more of boron, phosphorus, arsenic, antimony, hydrogen, helium, argon, germanium, fluorine, nitrogen, silicon, aluminum, indium, and xenon.

3. The method for evaluating an oxygen concentration according to claim 1 or 2, wherein
   the carbon concentration in the silicon single crystal is $1.0 \times 10^{14}$ (atoms/cm$^3$) or more.

## Patentansprüche

1. Verfahren zur Bestimmung der Sauerstoffkonzentration in einem Siliziumeinkristall durch ein Photolumineszenzverfahren oder ein Kathodenlumineszenzverfahren, wobei

der Siliziumeinkristall mit einem Elektronenstrahl mit einer vorbestimmten Dosis oder einem Ionenstrahl, der nicht Kohlenstoff oder Sauerstoff ist, mit einer vorbestimmten Dosis bestrahlt wird, die Intensität einer Emissionslinie (C-Linie), die von zusammengesetzten Defekten Ci-Oi von interstitiellem Kohlenstoff Ci und interstitiellem Sauerstoff Oi, die in dem Siliziumeinkristall gebildet sind, abgeleitet ist, und die Intensität einer Emissionslinie (G-Linie), die von zusammengesetzten Defekten Ci-Cs von interstitiellem Kohlenstoff Ci und substitutionellem Kohlenstoff Cs, die in dem Siliziumeinkristall gebildet sind, abgeleitet ist, bei einer vorbestimmten Temperatur gemessen werden, ein Intensitätsverhältnis der C-Linie und der G-Linie (Ci-Oi-Intensität/Ci-Cs-Intensität) bestimmt wird,
die Kohlenstoffkonzentration [Cs] im Siliziumeinkristall gemessen wird und
die Sauerstoffkonzentration [Oi] wird ermittelt durch
das Intensitätsverhältnis (Ci-Oi-Intensität/Ci-Cs-Intensität) und die Kohlenstoffkonzentration [Cs] im Siliziumeinkristall in die folgende Gleichung eingesetzt werden:

$[Oi]=\alpha \cdot$(Ci-Oi-Intensität/Ci-Cs-Intensität)$\cdot$[Cs] (wobei $\alpha$ eine Proportionalitätskonstante ist), wobei
bei der Auswertung der Sauerstoffkonzentration im Voraus folgendes durchgeführt wird,
ein Testkristall, bei dem es sich um einen Siliziumeinkristall mit einer bekannten Sauerstoffkonzentration und einer bekannten Kohlenstoffkonzentration handelt, wird hergestellt,
der Testkristall wird mit dem Elektronenstrahl mit der vorbestimmten Dosis oder dem Ionenstrahl, der nicht Kohlenstoff oder Sauerstoff ist, mit der vorbestimmten Dosis bestrahlt, die Intensität einer C-Linie und die Intensität einer G-Linie, die in dem Testkristall gebildet werden, werden bei einer vorbestimmten Temperatur gemessen, ein Intensitätsverhältnis der C-Linie und der G-Linie (Ci-Oi-Intensität/Ci-Cs-Intensität) in dem Testkristall wird bestimmt, **dadurch gekennzeichnet, dass**
ein Wert der Proportionalitätskonstante $\alpha$ aus der Sauerstoffkonzentration und der Kohlenstoffkonzentration in dem Testkristall, dem Intensitätsverhältnis der C-Linie und der G-Linie in dem Testkristall (Ci-Oi-Intensität/Ci-Cs-Intensität) und der Gleichung bestimmt wird.

2. Verfahren zur Bestimmung der Sauerstoffkonzentration nach Anspruch 1, wobei
der Ionenstrahl zur Bestrahlung des Siliziumeinkristalls, der nicht Kohlenstoff oder Sauerstoff ist, ein Ionenstrahl aus einem oder mehreren der Elemente Bor, Phosphor, Arsen, Antimon, Wasserstoff, Helium, Argon, Germanium, Fluor, Stickstoff, Silizium, Aluminium, Indium und Xenon ist.

3. Verfahren zur Bestimmung der Sauerstoffkonzentration nach Anspruch 1 oder 2, wobei
die Kohlenstoffkonzentration in dem Siliziumeinkristall $1{,}0 \times 10^{14}$ (Atome/cm$^3$) oder mehr beträgt.

**Revendications**

1. Procédé d'évaluation d'une concentration en oxygène dans un monocristal de silicium par un procédé de photoluminescence ou un procédé de luminescence cathodique, dans lequel

le monocristal de silicium est irradié par un faisceau d'électrons à une dose prédéterminée ou un faisceau d'ions autre que le carbone ou l'oxygène à une dose prédéterminée, l'intensité d'une raie d'émission (raie C) issue des défauts composites Ci-Oi du carbone interstitiel Ci et de l'oxygène interstitiel Oi formés dans le monocristal de silicium et l'intensité d'une raie d'émission (raie G) dérivée des défauts composites Ci-Cs du carbone interstitiel Ci et du carbone de substitution Cs formés dans le monocristal de silicium sont mesurées à une température prédéterminée, un rapport d'intensité de la raie C et la raie G (intensité Ci-Oi/intensité Ci-Cs) est déterminé, une concentration en carbone [Cs] dans le monocristal de silicium est mesurée et
la concentration en oxygène [Oi] est évaluée par
substitution du rapport d'intensité (intensité Ci-Oi/intensité Ci-Cs) et de la concentration en carbone [Cs] dans le monocristal de silicium dans l'équation suivante :

$[Oi]=\alpha \cdot$(intensité Ci-Oi/intensité Ci-Cs)$\cdot$[Cs] (où $\alpha$ est une constante de proportionnalité),
dans lequel lors de l'évaluation de la concentration en oxygène, les opérations suivantes sont effectuées à l'avance :

un cristal test qui est un monocristal de silicium avec une concentration en oxygène connue et une concentration en carbone connue est préparé,

le cristal test est irradié avec le faisceau d'électrons à la dose prédéterminée ou le faisceau d'ions autres que le carbone ou l'oxygène à la dose prédéterminée, l'intensité d'une raie C et l'intensité d'une raie G formées dans le cristal test sont mesurées à une température prédéterminée, un rapport d'intensité de la raie C et de la raie G (intensité Ci-Oi/intensité Ci-Cs) dans le cristal test est déterminé, **caractérisé en ce que**

une valeur de la constante de proportionnalité $\alpha$ est déterminée à partir de la concentration en oxygène et de la concentration en carbone dans le cristal test, du rapport d'intensité de la raie C et de la raie G dans le cristal test (intensité Ci-Oi/ intensité Ci-Cs), et de l'équation.

2. Procédé d'évaluation d'une concentration en oxygène selon la revendication 1, dans lequel le faisceau d'ions pour irradier le monocristal de silicium autre que le carbone ou l'oxygène est un faisceau d'ions d'un ou plusieurs parmi le bore, le phosphore, l'arsenic, l'antimoine, l'hydrogène, l'hélium, l'argon, le germanium, le fluor, l'azote, le silicium, l'aluminium, l'indium et le xénon.

3. Procédé d'évaluation d'une concentration en oxygène selon la revendication 1 ou 2, dans lequel la concentration en carbone dans le monocristal de silicium est de $1,0 \times 10^{14}$ (atomes/cm$^3$) ou plus.

[FIG. 1]

| | | |
|---|---|---|
| | Preparation of test crystal<br>Irradiation with electron beam or ion beam<br>Measurement of C line intensity and G line intensity<br>Determination of intensity ratio of C line and G line<br>Determination of α of oxygen concentration relational equation | Preliminary test |

- - - - - - - - - - - - - - - - - - - - - - - - - - - - - - - - - - - - - - - - - - - - - - - - - - -

| | | |
|---|---|---|
| Step 1 | Preparation of silicon single crystal substrate for evaluation | Main test |
| Step 2 | Measurement of carbon concentration | |
| Step 3 | Irradiation with electron beam or ion beam<br>Measurement of C line intensity and G line intensity<br>Determination of intensity ratio of C line and G line | |
| Step 4 | Substitution into oxygen concentration relational equation to evaluate oxygen concentration | |

[FIG. 2]

[FIG. 3]

(Example) Oxygen concentration obtained by present method (ppma-JEITA)

Oi concentration obtained by FT-IR method (ppma-JEITA)

(Comparative Example)

[FIG. 4]

Frequency (number)

Oi concentration (ppma-JEITA)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H04344443 A
- JP 2015111615 A
- JP 2015156420 A
- JP 2015101529 A

**Non-patent literature cited in the description**

- **M. NAKAMURA et al.** *J.Electochem.Soc,* 1994, vol. 141, 3576